# FASCICULE DE BREVET EUROPEEN

(11) **EP 0 605 302 B1**
(45) Date de publication et mention de la délivrance du brevet: **03.06.1998**
(21) Numéro de dépôt: 93403156.8
(22) Date de dépôt: 23.12.1993
(51) Int. Cl.: G01L 9/12

(54) **Procédé de fabrication d'un capteur de pression utilisant la technologie silicium sur isolant et capteur obtenu**
Herstellungsverfahren für Druckwandler mittels der Silicium auf Isolation Technologie sowie derart hergestellte Wandler
Procedure for fabricating a pressure transducer using the silicon on isolation technique and transducer thus obtained

(30) Priorité: 28.12.1992 FR 9215772
(43) Date de publication de la demande: 06.07.1994
(73) Titulaire: COMMISSARIAT A L'ENERGIE ATOMIQUE, 75015 Paris Cédex 15 (FR)
(72) Inventeur: Diem, Bernard, F-38130 Echirolles (FR); Delaye, Marie-Thérèse, F-38100 Grenoble (FR)
(74) Mandataire: Dubois-Chabert, Guy

(56) Documents cités:
- WO-A-91/19177
- US-A- 4 420 790
- US-A- 4 665 610
- TRANSDUCERS '91 - DIGEST OF TECHNICAL PAPERS, 24 Juin 1991, SAN FRANCISCO (US) pages 188 - 191 S. SUGIYAMA ET AL. 'SURFACE MICROMACHINED MICRO-DIAPHRAGM PRESSURE SENSORS'

## Description

La présente invention a pour objet un procédé de fabrication d'un capteur de pression, utilisant la technologie silicium sur isolant ainsi que le capteur obtenu.

Ce capteur est utilisable dans tous les domaines où l'on souhaite mesurer une pression et notamment dans les domaines industriels tels que les domaines spatial et aéronautique, dans le domaine de la recherche et aussi pour des applications grand public comme l'automobile.

De nombreuses techniques ont été proposées pour réaliser des capteurs de pression ou des structures mécaniques pour capteurs en silicium micro-usiné, utilisant les technologies de la microélectronique.

L'avantage principal du silicium est évidemment le traitement collectif des structures et leurs miniaturisations, donc un prix de revient relativement bas, mais aussi la fiabilité mécanique du matériau monocristallin utilisé qui ne présente ni fluage, ni hystérésis, ni dérive dans le temps.

Cependant, pour une utilisation encore plus large de ces capteurs, il est nécessaire de réduire encore le coût unitaire de la puce en diminuant sa surface, tout en conservant des qualités métrologiques acceptables.

Les technologies classiques pour la fabrication de capteurs de pression utilisent l'usinage chimique anisotrope en volume de silicium, c'est-à-dire que toute l'épaisseur du substrat est gravée pour libérer une structure monocristalline sensible.

Les inconvénients majeurs que l'on peut citer pour cette technique en volume sont : l'utilisation d'une technique double face (machines spécifiques peu nombreuses et chères et substrats polis sur deux faces) ; une forme du capteur liée à l'orientation cristalline du substrat et donc une limitation de ces formes ; une miniaturisation du capteur limitée par l'épaisseur du substrat (structure en trois dimensions dont une dimension est fixée), et la nécessité de réaliser un scellement du capteur sur un ou plusieurs substrats nécessitant l'emploi de cavités de référence et de support de structure compliquant quelque peu la fabrication de ces capteurs.

Cette technique en volume est notamment décrite dans la référence 1 - Transducers' 91 Digest of Technical papers, San Francisco, "Stability and common mode sensitivity of piezoresistive silicon pressure sensors made by different mounting methods" de R. Holm et al, p. 978-981.

D'une manière générale, le principe de base mis en jeu dans un capteur de pression en silicium est la mesure de la déformation d'une membrane déformable en silicium liée mécaniquement à un support, sous l'action d'une variation de pression.

Pour réaliser les capteurs de pression selon une technique en volume, il est nécessaire d'avoir une couche sélective lors de la gravure du substrat permettant d'obtenir un arrêt de l'attaque à une profondeur bien contrôlée. En outre, pour des raisons de résistance mécanique et aussi de caractéristique électrique, il est très important que la structure dégagée soit en silicium monocristallin.

Les techniques d'arrêt de gravure utilisées sont soit la gravure d'un substrat massif de silicium par la face arrière avec arrêt sur une couche épitaxiée de silicium fortement dopé au bore (voir la référence 2 - J. Electrochem. Soc., vol. 137, n°11, novembre 1990, "Anisotropic etching of crystalline silicon in alkaline solutions : II. Influence of dopants" de H. Seidel et al., p. 3626-3632 -), soit une gravure électrochimique du substrat en silicium avec arrêt de l'attaque sur une couche de silicium épitaxiée formant une jonction P/N avec le substrat (voir la référence 3 - IEEE Transactions on Electron Devices, vol. 36, n°4, avril 1989, "Study of electrochemical etch-stop for high-precision thickness control of silicon membranes" de B. Kloeck et al., p.663-669 -).

Ces deux techniques d'arrêt de gravure présentent les inconvénients mentionnés ci-dessus. En effet, elles utilisent une gravure anisotrope du substrat, limitant les formes des éléments sensibles du fait de l'orientation cristalline du substrat, ainsi qu'une attaque par face arrière nécessitant l'emploi de substrats spéciaux et l'utilisation d'une technique d'alignement double face.

Par ailleurs, ces techniques d'arrêt nécessitent l'emploi de masques de gravure très sélectifs et, compte tenu des plans d'attaque inclinés (54,7° pour le silicium d'orientation 100) et de l'épaisseur du silicium à graver, les formes réalisées sur la face arrière sont très supérieures aux formes utiles finales du composant.

L'emploi de ces masques de gravure très sélectifs est en particulier lié à l'épaisseur importante de substrat en silicium à graver.

Lorsque l'élément sensible est terminé, il est ensuite nécessaire de le sceller sur un ou plusieurs supports épais et rigides pour obtenir un capteur. Ce ou ces supports sont en général de nature différente de celle du substrat (par exemple en verre), ce qui conduit à des contraintes différentielles préjudiciables aux performances du capteur et à une étape délicate supplémentaire à réaliser.

Une autre voie de fabrication des capteurs de pression consiste à utiliser une technique d'usinage de surface à l'aide d'une couche sacrificielle et d'une couche déposée de silicium polycristallin, réalisant la structure mécanique désirée. Cette voie est décrite dans la référence 4 - Transducer's 87, Tokyo, Juin 1987, "Fine grained polysilicon and its application to planar pressure transducers" de H. Guckel et al., p. 277-282. On peut se reporter également au document "Surface micromachined micro-diaphragm pressure" de S. Sugiyama et al., page 190, Transducers 91 - Digest of technical papers, 24 juin 1991.

Cette technique permet de réaliser des capteurs de pression en technologie simple face grâce à l'utilisation de la couche sacrificielle. Cet usinage de surface a le grand avantage d'associer une technique simple à des structures de très petites dimensions.

Malheureusement, cette technique de surface présente des inconvénients. En particulier, les qualités mécaniques du matériau constitutif de la membrane (silicium polycristallin ou nitrure de silicium) sont médiocres et des contraintes thermiques différentielles importantes sont induites du fait de l'utilisation de matériaux différents pour la membrane et le substrat ; il s'ensuit des capteurs de pression de qualités métrologiques limitées, voire insuffisantes.

De plus, en raison de leur nature, ces dépôts ont une épaisseur limitée à quelques micromètres (inférieure à 2µm en général), ce qui réduit les possibilités de forme et de dimension et interdit pratiquement l'utilisation d'une détection piézorésistive de la pression.

Pour remédier à ces différents inconvénients, l'invention propose un nouveau procédé de fabrication d'un capteur de pression, utilisant la technologie silicium sur isolant, associée à un micro-usinage de surface.

La technologie silicium/isolant est connue sous l'abréviation SOI. L'une des techniques connues fait appel à la recristallisation par laser d'une couche de silicium amorphe ou polycristallin, déposée sur une couche d'oxyde de silicium obtenue par oxydation thermique d'un substrat de silicium monocristallin. Une seconde technique connue sous l'abréviation SDB consiste à réaliser le scellement de deux substrats en silicium dont un au moins possède sur la surface de scellement une couche de SiO₂ obtenue par exemple par oxydation thermique et à amincir ensuite un des deux substrats jusqu'à une épaisseur désirée (voir Technical Digest MNE'90, 2nd Workshop, Berlin, novembre 90, p. 81- 86 de C. Harendt et al., "Wafer bonding and its application silicon-on-insulator fabrication".

Une troisième technique connue est basée sur l'implantation d'ions oxygène ou d'azote à forte dose dans du silicium monocristallin massif qui, après recuit du substrat à haute température, conduit à la formation d'une couche isolante enterrée d'oxyde de silicium ou de nitrure de silicium supportant un film de silicium monocristallin. La technologie à implantation d'ions oxygène est connue sous la terminologie SIMOX.

L'invention retient en particulier cette troisième technique.

Le document WO91/19177 décrit par ailleurs un capteur comportant une membrane déformable et pouvant fonctionner par effet capacitif ou par effet piézorésistif. Des électrodes sont à cet effet formées sur le substrat avant la réalisation des couches de silicium et d'isolant, sous la forme d'une jonction p/n. Un tel procédé n'est cependant pas compatible avec la technologie SIMOX retenue par la présente invention. La technologie SIMOX nécessite de porter le dispositif à une température élevée, voisine de 1350°C pendant environ 6 heures pour former la couche isolante et pour restaurer la qualité cristalline dégradée lors de l'implantation. Dans ces conditions, toute réalisation antérieure par dopage, comme la formation d'une électrode isolée, à l'aide d'une jonction p/n est détruite ou altérée par diffusion des espèces.

Le procédé de l'invention permet l'obtention de structures mécaniques en silicium monocristallin et donc de bonnes qualités métrologiques, de dimensions très petites et donc de densité élevée, abaissant ainsi le coût de fabrication. Ce procédé permet de plus de réaliser des capteurs de pression qui peuvent être auto-testables pour le calibrage avec une détection capacitive.

Par ailleurs, le procédé de l'invention permet la fabrication monolithique et collective de micro-capteurs, avec toute liberté sur la forme de la structure, en utilisant une technologie simple face et des substrats de silicium standards, polis sur une face et d'épaisseur standard présentant un encombrement très faible.

En outre, ce procédé permet de supprimer l'étape critique de scellement du capteur sur un support de nature différente ainsi qu'une intégration des circuits intégrés de détection des déformations de la membrane. En particulier, cette technologie est compatible avec la technologie CMOS.

Enfin, le procédé de l'invention permet d'obtenir des capteurs à très bas prix de revient.

De façon plus précise, l'invention a pour objet un procédé de fabrication d'un capteur de pression intégré, comportant au moins une membrane déformable solidaire d'un substrat et des moyens de mesure des déformations de cette membrane, caractérisé en ce qu'il comprend les étapes suivantes :
a) - implantation d'ions oxygène dans un substrat en silicium monocristallin et recuit du substrat pour former un film de silicium monocristallin sur le substrat et séparé de ce dernier, au moins localement, par une couche isolante ;
b) - réalisation d'une ouverture dans le film de silicium jusqu'à la couche isolante ;
c) - élimination partielle de la couche isolante via ladite ouverture pour former la membrane dans le film de silicium ;
d) - reboucher ladite ouverture,
ledit procédé comportant en outre une étape de fabrication d'au moins une électrode enterrée dans le substrat de silicium, en regard de la membrane déformable, cette étape ayant lieu après le recuit du substrat.

Les moyens de détection des déplacements de la membrane peuvent être intégrés ou non à la structure sensible. Lorsque ces moyens sont intégrés, ils sont réalisés en surface du film de silicium. Dans ce cas, le film de silicium est avantageusement conducteur et une étape supplémentaire de fabrication de contacts électriques sur ce film doit être prévue.

Ces moyens de détection sont du type électrique ou électronique. Ces moyens peuvent consister en des condensateurs à capacité variable, en des jauges de contrainte ou en des dispositifs inductifs. Les signaux électriques fournis par ces différents moyens de détection sont proportionnels aux déformations de la membrane, elles-mêmes proportionnelles à la pression exercée sur le capteur.

La couche isolante est avantageusement attaquée d'une façon isotrope afin d'obtenir des formes parfaitement circulaires, définissant la forme finale de la structure, indépendamment de l'orientation cristalline du silicium du film et du substrat.

De façon avantageuse, le procédé de l'invention comporte une étape supplémentaire de dépôt par épitaxie d'une couche de silicium monocristallin conducteur avant la réalisation de l'ouverture, en vue d'épaissir la membrane et d'assurer ainsi sa rigidité.

Le silicium épitaxié doit en outre être dopé afin d'assurer une conductivité électrique suffisante de la membrane et donc une bonne détection des éventuelles déformations de la membrane par les moyens de détection intégrés.

Le procédé de l'invention s'applique particulièrement à la technique SIMOX citée précédemment.

L'implantation d'ions peut avoir lieu en une ou plusieurs fois, chaque implantation étant suivie du recuit de la structure.

Le film de silicium et éventuellement le substrat lorsque ce dernier est à l'origine de la fabrication du film de surface peuvent présenter une conductivité P. Il est toutefois préférable d'utiliser une conductivité N.

Le rebouchage de l'ouverture dans le film de silicium est effectué en déposant sur l'ensemble de la structure au moins une couche de matériau que l'on peut graver sélectivement par rapport au silicium et en gravant cette couche de façon à ne garder du matériau qu'à l'emplacement des ouvertures.

Le rebouchage de l'ouverture dans le film permet de former également à cet endroit un plot qui prend appui sur le substrat et qui forme une cale contribuant à la rigidité de la membrane.

Avantageusement, le rebouchage est effectué par un matériau isolant. Celui-ci peut consister en de l'oxyde de silicium, du nitrure de silicium, de l'oxynitrure de silicium ou mieux en un empilement d'oxyde de silicium et de nitrure de silicium. Le matériau de rebouchage peut toutefois être conducteur.

Le procédé de l'invention s'applique avantageusement à la fabrication d'un capteur de pression à moyens de mesure capacitifs. Dans ce cas, le procédé de l'invention comporte une étape supplémentaire de fabrication d'au moins une électrode enterrée dans le substrat en silicium, en regard de la membrane.

La réalisation de l'électrode enterrée constitue un mode de mise en oeuvre préféré de l'invention. Il est toutefois possible d'utiliser le substrat conducteur comme première armature d'un condensateur, la seconde armature étant formée par le film de silicium conducteur.

Cette électrode enterrée peut être formée en implantant localement des ions dans le substrat, présentant une conductivité inverse de celle du substrat.

Ainsi, pour un substrat de type N on effectue une implantation d'ions de type P de façon à former une jonction P/N.

Pour un capteur à moyens de mesure capacitifs, la couche isolante est formée avantageusement sur toute la surface du substrat.

Pour s'affranchir des dérives thermiques ou temporelles du capteur, il est possible d'utiliser une mesure différentielle capacitive en réalisant une structure de référence non sensible à la pression, similaire à la structure sensible du capteur. Cette structure de référence comporte donc une membrane rigide et est réalisée simultanément sur le substrat de silicium de la structure sensible.

Dans ce cas, le procédé de l'invention comporte avantageusement les étapes suivantes :
- réalisation du film de silicium conducteur séparé du substrat sur toute sa surface ;
- réalisation de plusieurs ouvertures dans le film de silicium jusqu'à la couche isolante ;
- élimination partielle de la couche isolante via au moins une desdites ouvertures ;
- rebouchage desdites ouvertures par des plots isolants ;
- réalisation de contacts électriques sur le silicium conducteur.

Les plots assurent une rigidité importante de la membrane de la structure de référence qui perd ainsi toute sensibilité à la pression.

De façon avantageuse, on réalise dans le film une première ouverture jusqu'à la couche isolante, une élimination partielle de la couche isolante via la première ouverture et des secondes ouvertures dans le film de silicium.

De préférence, on réalise au moins une électrode de référence enterrée dans le substrat en silicium, en regard de la membrane rigide.

La souplesse sur les dimensions latérales de la membrane déformable et de la membrane rigide ainsi que sur leur épaisseur permet de réaliser une gamme de mesures très large de la pression.

Selon une variante de l'invention, une mesure capacitive différentielle peut avoir lieu également sans structure de référence non-sensible additionnelle. A cet effet, la structure sensible est équipée de deux types d'électrodes. D'une part une ou plusieurs électrodes dites "utiles" sont situées sur le substrat et en face de régions de déformation importante de la membrane, et d'autre part, une ou plusieurs électrodes dites de "référence" sont situées sur le substrat et en face de régions de déformation très faible de la membrane. Les régions de forte déformation sont distantes de la périphérie de la membrane et du plot central. Les régions de faible déformation sont au contraire au voisinage de ces parties qui contribuent au raidissement de la membrane. Ainsi, l'inhomogénéité de la membrane est mise à profit pour créer deux types de capacités, désignées respectivement par capacité "utile" et de "référence". Par mesure différentielle entre les capacités "utile" et de "référence" les effets parasites dus à la température ou à la fatigue mécanique de la membrane sont éliminés.

L'invention s'applique aussi à la fabrication d'un capteur de pression à moyens de mesure piézorésistifs. Dans ce cas, le procédé de l'invention comprend les étapes suivantes : dopage local de la membrane déformable par des ions de conductivité inverse de celle du film de silicium pour y former au moins une jauge de contrainte ; isolation électrique de la jauge et prise de contact électrique sur ladite jauge.

L'invention a aussi pour objet un capteur de pression intégré obtenu par le procédé décrit précédemment.

D'autres caractéristiques et avantages de l'invention ressortiront mieux de la description qui va suivre, donnée à titre illustratif et non limitatif, en référence aux dessins annexés, dans lesquels :
- la figure 1 représente schématiquement en vue de dessus la structure sensible d'un capteur de pression conforme à l'invention à détection capacitive,
- la figure 2 est une vue en coupe selon la direction II-II de la figure 1,
- la figure 3 est une vue en coupe de la structure de référence du capteur de la figure 1,
- la figure 4 est une vue en coupe et à échelle agrandie d'une variante de structure sensible selon l'invention,
- les figures 5 à 8, 9A, 9B, 10A et 10B illustrent schématiquement les différentes étapes de fabrication conformément à l'invention du capteur des figures 1 à 3 : les figures 9A et 10A concernent la structure sensible et les figures 9B et 10B concernent la structure de référence ;
- la figure 11 représente schématiquement en coupe un capteur de pression conforme à l'invention à détection piézorésistive ;
- les figures 12 à 17 illustrent schématiquement les différentes étapes de fabrication conformément à l'invention du capteur de la figure 11.

La description qui suit sera faite en utilisant la technique SIMOX ainsi que l'emploi d'un substrat monocristallin de type N, mais comme on l'a vu précédemment, d'autres techniques de silicium/isolant ainsi que l'emploi d'un substrat de type P peuvent être envisagées.

### 1°) - Capteur de pression à détection capacitive.

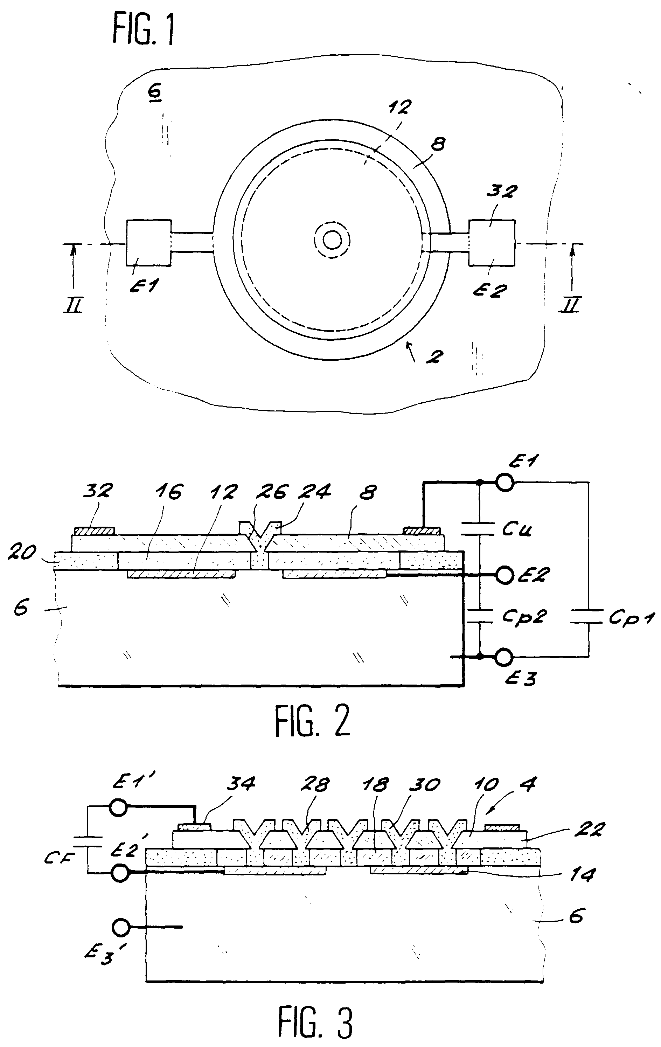

Le capteur représenté sur les figures 1 à 3 comprend une partie sensible de référence générale 2 et une partie de référence 4 réalisée sur le même substrat 6 en silicium monocristallin dopé N, pourvues respectivement d'une membrane déformable 8 et d'une membrane rigide 10 aussi en silicium monocristallin dopé N ou P.

Les membranes déformable et rigide présentent, en vue de dessus (figure 1) une forme circulaire. Elles ont un diamètre de 25µm à 1mm environ.

Du fait de la conductivité électrique des membranes 8 et 10, celles-ci définissent chacune avec le substrat 6 un condensateur, de capacité Cu pour la structure sensible 2, dont le diélectrique est constitué par l'espace sous vide respectivement 16 et 18 séparant les membranes du substrat.

Cp1 est la capacité parasite de la membrane déformable.

Les structures déformable et de référence comportent en outre chacune une électrode respectivement 12 et 14 enterrée dans le substrat 6. Ces électrodes présentent aussi une forme circulaire. Ces électrodes sont obtenues par implantation d'ions de type P pour un substrat de type N afin de former une jonction P/N.

La qualité de cette jonction n'est pas critique car elle agit comme une capacité parasite notée Cp2 par rapport au substrat 6. Ces électrodes sont préférées mais non nécessaires du fait de la conductivité électrique du substrat 6.

La liaison mécanique entre le substrat et les membranes est assurée par un anneau isolant respectivement 20 et 22 formé à la périphérie des membranes respectivement 8 et 10. Ces anneaux assurent en outre une isolation électrique des membranes vis-à-vis du substrat.

Les anneaux isolants 20 et 22 sont réalisés en oxyde de silicium. Cette isolation électrique est complétée par une gravure périphérique des membranes 8 et 10 rompant la continuité électrique et diminuant les capacités parasites.

Afin d'assurer une certaine rigidité de la membrane déformable 8, un plot 24 isolant de forme cylindrique est prévu au milieu de la structure. Ce plot joue le rôle de bouchon 24 d'une ouverture 26 qui traverse la membrane 8 et prend appui sur le substrat 6.

Parallèlement, la structure de référence 4 comporte plusieurs plots isolants 28, au nombre de 5 sur la figure 3, de forme cylindrique assurant une rigidité élevée de la membrane 10 et donc une insensibilité à la pression de celle-ci. Ces plots 28 traversent cette membrane par l'intermédiaire d'ouvertures 30, pour venir s'appuyer sur le substrat 6.

Enfin, des contacts métalliques respectivement 32 et 34 sont formés en surface respectivement des membranes 8 et 10, sur lesquels viennent se connecter des liaisons électriques respectivement E1 et E'1. De même, des prises de contacts électriques respectivement E2, E'2 et E3, E'3 sont prévues sur les électrodes enterrées 12, 14 et le substrat.

Ces liaisons électriques servent à connecter les structures sensible 2 et de référence 4 à un circuit de traitement de type connu (capacimètre notamment).

Le condensateur utile à capacité Cu variable est donc défini par le recouvrement des électrodes 12 et 8. De même, le condensateur à capacité fixe CF, destiné à la mesure différentielle, est défini par le recouvrement des électrodes 14 et de l'électrode 10.

Les plots isolants 24 et 30 sont réalisés en un matériau bicouche oxyde de silicium/nitrure de silicium. En outre, les métallisations 32 et 34 sont réalisées en aluminium.

Selon l'invention, il est possible d'associer plusieurs membranes déformables 8. En effet, La miniaturisation des membranes 8 permet par un couplage en parallèle de celles-ci d'obtenir une capacité unitaire Cu élevée (>10pF/mm²) et une redondance intéressante pour le rendement. La structure de référence permet une mesure différentielle permettant de s'affranchir des dérives thermiques et temporelles.

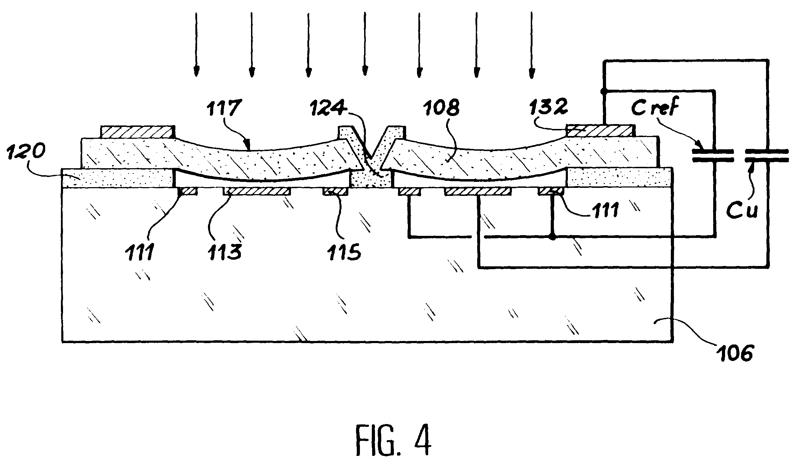

Une variante de l'invention, adaptée également à une mesure différentielle, mais ne comprenant qu'une structure déformable 102 est illustrée à la figure 4. De même que la structure sensible de la figure 2, celle-ci comporte un substrat 106, une membrane 108 et une ou plusieurs prises de contact 132. La membrane, de forme circulaire 108 est mécaniquement reliée au substrat 106 par un anneau isolant 120 et par un plot isolant central 124. Ce plot qui joue également un rôle de bouchon, prend appui sur le substrat 106 et contribue à la rigidité de la membrane 108. Dans le substrat 106 sont implantées trois électrodes annulaires 111, 113 et 115. Les électrodes 111 et 115 dite de "référence" sont disposées respectivement à proximité de l'anneau 120 et du plot 124, c'est-à-dire dans des régions de faible déformation de la membrane 108. L'électrode 113 par contre est située à distance de l'anneau 120 et du plot 124, dans une région 117 de déformations importantes de la membrane 108.

Les électrodes 111 et 115 d'une part et l'électrode 113 d'autre part forment respectivement avec la membrane 108 une capacité de référence C_{ref}, et une capacité utile Cᵤ. La pression s'exerçant sous l'effet de la pression sur la membrane est schématisée par des flèches. La variation d'entrefer dans les régions des électrodes 111 et 115 est très faible. Dans la région 117 par contre, c'est-à-dire dans la région de l'électrode 115, la variation de l'entrefer est importante. Les capacités utile et de référence étant formées sous une même membrane, il n'y a aucun décalage lors d'une mesure différentielle.

La description qui suit concerne la fabrication du capteur représenté sur les figures 1 à 3. Cette fabrication concerne la réalisation simultanée de la structure sensible 2 et de la structure de référence 4.

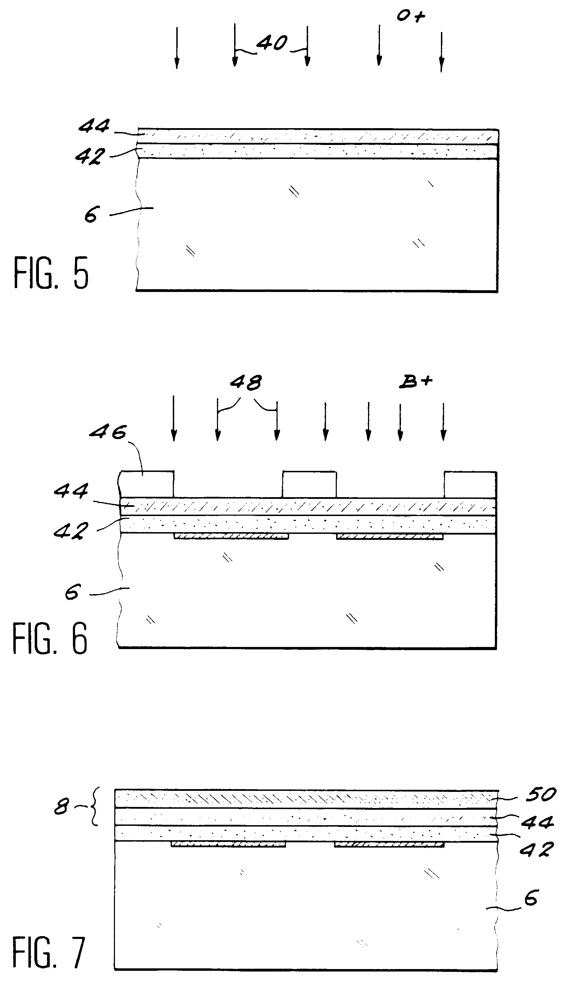

La première étape du procédé, représentée sur la figure 5, consiste à former un empilement du type silicium/isolant sur le substrat 6. A cet effet, on implante des ions oxygène 40 (O+ ou O₂+) dans le substrat 6 monocristallin dopé N d'orientation quelconque (100, 110, 101), à une dose de 1016 à 1018 ions/cm², puis on recuit la structure implantée à une température allant de 1150°C à 1400°C.

Cette implantation d'oxygène et ce recuit peuvent être répétés plusieurs fois. L'énergie d'implantation est choisie entre 100 et 1000KeV.

Cette mono- ou multi-implantation suivie de son recuit permet l'obtention d'une couche d'oxyde de silicium 42 homogène enterrée, sur toute la surface du substrat 6, et une couche superficielle 44 de silicium monocristallin N.

A titre d'exemple, l'épaisseur de la couche 42 de SiO₂ est d'environ 400nm et celle de la couche superficielle 44 de silicium d'environ de 230nm en utilisant trois implantations d'oxygène à une dose de 10¹⁸ions/cm et une énergie de 200KeV.

Cette technique SIMOX permet l'obtention d'une couche de silicium monocristallin 44 d'épaisseur parfaitement contrôlable et reproductible à 5nm près.

L'élimination partielle ultérieure de l'oxyde 42 permettra de libérer les membranes 8 et 10 du substrat 6 et la réalisation d'espaces 16 et 18 parfaitement maîtrisés et étroits permettant ainsi d'obtenir une capacité Cu et CF de valeur élevée.

Un avantage supplémentaire lié à l'espace 16 est la possibilité d'utiliser le fond de cet espace et donc la surface du substrat 6 comme butée mécanique en cas de surcharge.

La réalisation de la variante de l'invention représentée à la figure 4 comporte des étapes analogues aux étapes de fabrication du capteur des figures 1 à 3.

Dans la suite de la description, on ne montrera les étapes de fabrication de la structure de référence uniquement lorsque celles-ci seront spécifiques et/ou différentes de celles de la structure sensible.

L'étape suivante du procédé représenté sur la figure 6 concerne la fabrication des électrodes enterrées dans le substrat. A cet effet on forme un masque 46 sur le film de silicium 44, par les procédés classiques de photolithographie, fixant la forme et l'emplacement des électrodes enterrées à réaliser ainsi que la liaison électrique E2, E'2 enterrée de ces électrodes permettant, entre autres, l'application d'une tension sur ces électrodes enterrées.

A travers le masque 46, on réalise une implantation 48 profonde de bore à haute énergie, sous la couche d'oxyde enterrée 44. Les conditions d'implantation peuvent être par exemple une dose de 5x10¹⁴At/cm² à une énergie de 240keV afin d'obtenir une zone dopée de type P de bonne conductivité électrique et d'épaisseur d'environ 0,3µm juste au-dessous de la couche enterrée 44 et ce, dans la zone non masquée par la résine 46. Ce masque 46 devra être suffisamment épais afin de bloquer l'implantation sur les zones non désirées. Une épaisseur de 2µm par exemple de résine photosensible pourra être utilisée.

Cette implantation réalisée, on enlève le masque 46 par exemple par attaque chimique.

L'étape suivante de procédé, représentée sur la figure 7, consiste à épitaxier sur l'ensemble de la structure une couche 50 de silicium monocristallin dopé P, sur une épaisseur de 1 à 100µm suivant la sensibilité désirée pour le capteur (typiquement 10 à 20µm), destinée à rigidifier la structure et notamment les membranes 8 et 10. Cette épitaxie est réalisée en phase vapeur.

L'épaisseur de la couche 50 est fonction de la sensibilité désirée pour le capteur de pression.

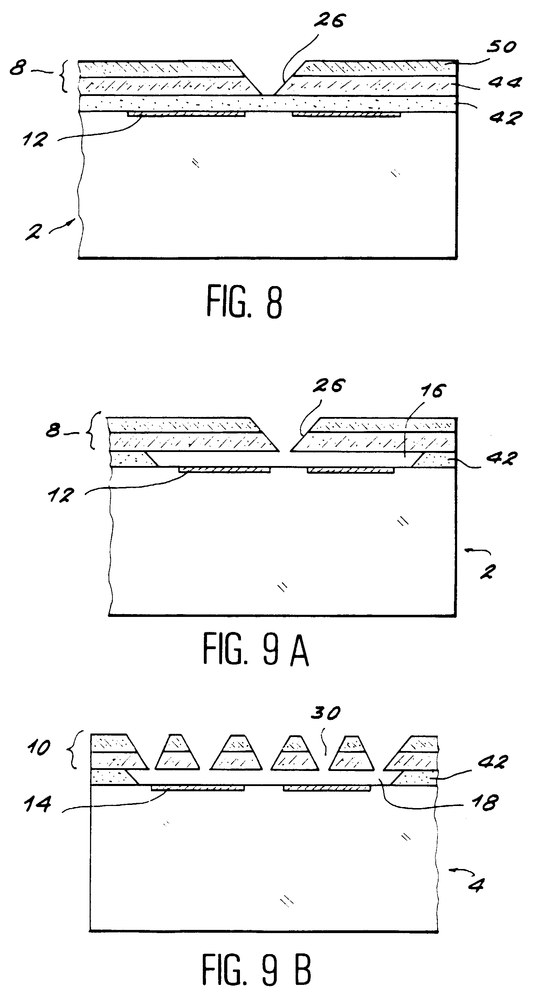

L'étape suivante du procédé représentée sur la figure 8 consiste à réaliser l'ouverture 26 de la structure sensible 2 et de la structure de référence 4 (voir figure 9B) en utilisant les procédés classiques de photolithographie. Ces ouvertures sont réalisées sur toute l'épaisseur du silicium de surface jusqu'à l'oxyde 42 qui sert de couche d'arrêt de gravure.

La gravure du silicium peut être une gravure chimique isotrope ou une gravure sèche ionique et réactive de façon à réaliser un flanc de gravure en pente des ouvertures 26. Ces ouvertures sont en outre circulaires.

On utilise par exemple une solution de HF+HNO₃+CH₃COOH pour former ces ouvertures 26.

L'étape suivante du procédé représentée sur les figures 9A et 9B consiste à libérer les membranes 8 et 10 respectivement des structures sensible 2 et de référence 4 par gravure de la couche sacrificielle d'oxyde 42 dans une solution à base d'acide fluorhydrique à partir des ouvertures 26. Cette gravure se propage de façon concentrique sous le silicium du fait de sa nature isotrope permettant ainsi de former des espaces 16 et 18 circulaires et de maintenir de l'oxyde à la périphérie des structures 2 et 4.

La vitesse de gravure latérale est parfaitement reproductible et de l'ordre de 1µm/min à température ambiante, ce qui permet un contrôle dimensionnel précis de l'épaisseur latérale des anneaux isolants 20 et 22 (figures 2 et 3) en fonction du temps.

Une fois le temps de gravure nécessaire écoulé, l'échantillon est rincé et séché, les membranes 8 et 10 minces sont alors terminées.

L'étape suivante consiste à réaliser les ouvertures 30 dans la membrane 10 de la structure de référence 4 dans les mêmes conditions que pour les ouvertures 26.

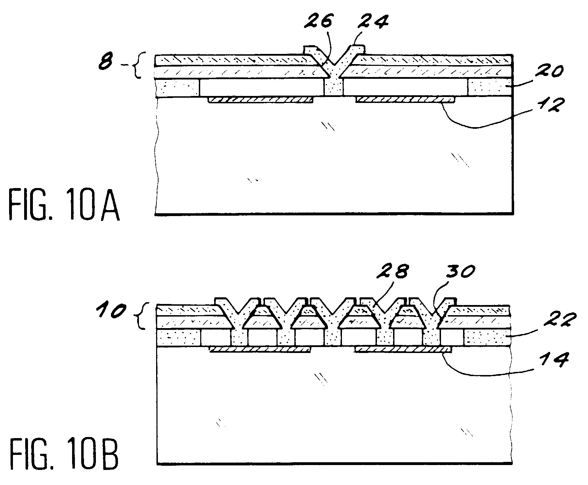

L'étape suivante du procédé représentée sur les figures 10A et 10B concernent le rebouchage des ouvertures 26 et 30. Ce rebouchage est effectué en maintenant les espaces 16 et 18 sous vide pour obtenir un capteur absolu. Pour ce faire, on effectue un dépôt sous vide permettant d'une part de réaliser des bouchons 24 et 28 hermétiques au niveau des ouvertures 26 et 30 et d'autre part, d'obtenir des plots supports entre les membranes 8 et 10 respectivement et le substrat.

Ces plots permettent d'augmenter la rigidité de la membrane 10 et de conférer à la membrane déformable 8 une déformation circulaire plus favorable pour une détection capacitive qu'une déformation dite "ballon". Les plots 26 et 28 sont obtenus par dépôt sur l'ensemble de la structure d'un empilement de SiO₂ + Si₃N₄ déposé par dépôt chimique en phase vapeur éventuellement assisté plasma. L'épaisseur de l'empilement déposée doit être de l'ordre de 1µm afin de bien obstruer les ouvertures 26 et 30 et de former des cales entre les membranes et le substrat.

Une étape de gravure de l'empilement de couches est ensuite effectuée pour ne conserver cet empilement qu'aux endroits désirés, c'est-à-dire au niveau des ouvertures 26 et 30 et libérer ainsi les membranes 8 et 10 de toute contrainte parasite.

On effectue alors le dépôt d'une couche métallique sur l'ensemble de la structure pour assurer les interconnexions avec le circuit de mesure ainsi que les prises de contact 32 et 34 sur les structures 2 et 4. Cette métallisation a une épaisseur d'environ 0,5 à 1µm et peut être en aluminium. Cette couche est alors gravée pour former les contacts 32 et 34 selon les procédés classiques de photolithogravure. L'attaque de l'aluminium peut être réalisée à l'aide de H₃PO₄.

On effectue ensuite une gravure du silicium superficiel à la périphérie des membranes 8 et 10 (voir figures 1 et 3) pour isoler les structures de mesure et de référence l'une de l'autre et diminuer les capacités parasites. Cette gravure peut être réalisée par gravure ionique réactive en utilisant du SF₆.

## Revendications

1. Procédé de fabrication d'un capteur de pression intégré, comportant au moins une membrane déformable solidaire d'un substrat et des moyens capacitifs de mesure des déformations de cette membrane, caractérisé en ce qu'il comprend les étapes suivantes :
a) - implantation d'ions oxygène dans un substrat (6) en silicium monocristallin et recuit du substrat pour former un film de silicium monocristallin (44) sur le substrat et séparé de ce dernier, au moins localement, par une couche isolante (42) ;
b) - réalisation d'une ouverture (26) dans le film de silicium jusqu'à la couche isolante ;
c) - élimination partielle de la couche isolante via ladite ouverture pour former la membrane dans le film de silicium ;
d) - reboucher ladite ouverture (26),
ledit procédé comportant en outre une étape de fabrication d'au moins une électrode enterrée (12, 111, 113, 115) dans le substrat de silicium, en regard de la membrane déformable, cette étape ayant lieu après le recuit du substrat.

2. Procédé selon la revendication 1, caractérisé en ce que l'étape c) est réalisée par attaque chimique isotrope.

3. Procédé selon la revendication 1 ou 2, caractérisé en ce qu'on épitaxie une couche de silicium monocristallin (50) sur le film de silicium avant la réalisation de l'ouverture.

4. Procédé selon l'une quelconque des revendications 1 à 3, caractérisé en ce que l'on forme les moyens de mesure (8, 12) au moins en partie, dans le film de silicium et/ou la couche de silicium épitaxiée qui sont alors conducteurs et en ce qu'on réalise des contacts électriques (32, 34) sur le silicium conducteur pour lesdits moyens.

5. Procédé selon l'une quelconque des revendications précédentes, caractérisé en ce que le substrat est en silicium monocristallin dopé N.

6. Procédé selon l'une quelconque des revendications précédentes, caractérisé en ce que l'étape d) consiste à déposer sur l'ensemble de la structure au moins une couche additionnelle et à graver cette couche de façon à ne garder du matériau qu'à l'emplacement de l'ouverture.

7. Procédé selon la revendication 6, caractérisé en ce que l'on utilise un empilement de deux couches isolantes respectivement en oxyde de silicium et nitrure de silicium pour reboucher l'ouverture.

8. Procédé selon l'une quelconque des revendications précédentes, caractérisé en ce que l'électrode enterrée est formée par implantation locale d'ions dans le substrat d'un type de conductivité inverse de celle du substrat.

9. Procédé selon l'une quelconque des revendications précédentes, caractérisé en ce que la couche isolante (42) est formée sur toute la surface du substrat.

10. Procédé selon l'une quelconque des revendications précédentes, de fabrication d'un capteur à moyens de mesure capacitifs différentielle, caractérisé en ce qu'il comprend, en outre, la fabrication simultanée d'une structure de référence (4) à membrane rigide (10), intégrée sur ledit substrat, comprenant les étapes suivantes :
- réalisation du film de silicium conducteur séparé du substrat sur toute sa surface ;
- réalisation de plusieurs ouvertures (26, 30) dans le film de silicium jusqu'à la couche isolante;
- élimination partielle de la couche isolante via au moins une (26) desdites ouvertures ;
- rebouchage desdites ouvertures par des plots isolants (28) ;
- réalisation de contacts électriques (34) sur le silicium conducteur.

11. Procédé selon la revendication 10, caractérisé en ce qu'on réalise dans le film de silicium une première ouverture (26) jusqu'à la couche isolante, une élimination de la couche isolante via cette première ouverture et des secondes ouvertures (30) dans le film de silicium.

12. Procédé selon la revendication 10 ou 11, caractérisé en ce qu'on réalise au moins une électrode de référence (14) enterrée dans le substrat en silicium, en regard de la membrane rigide (10).

13. Procédé selon l'une quelconque des revendications 1 à 14, caractérisé en ce qu'on effectue, en outre, une gravure périphérique du silicium formé sur la couche isolante pour isoler la ou les membranes (8, 10).

14. Capteur de pression intégré, comprenant une structure sensible (2) comportant un substrat en silicium (6, 106), au moins une membrane en silicium monocristallin déformable (8, 108) selon une direction (Z) perpendiculaire au substrat, et des moyens à condensateur pour la mesure des déformations de la membrane, ladite membrane étant solidaire du substrat par sa périphérie grâce à une couche isolante (42, 42a) gravée, caractérisé en ce que la membrane comporte en son milieu un plot isolant (24, 124), ledit plot prenant appui sur le substrat pour augmenter la rigidité de la membrane, et en ce qu'au moins une électrode enterrée (12) dans le substrat est prévue en regard de la membrane déformable.

15. Capteur selon la revendication 14, caractérisé en ce que la membrane est circulaire.

16. Capteur selon la revendication 14, caractérisé en ce qu'il comprend une structure de référence comportant au moins une membrane (10) en silicium monocristallin solidaire du substrat, et rendue rigide grâce à plusieurs plots isolants (28) répartis sur toute sa surface et prenant appui sur le substrat, des contacts électriques (34) étant formés sur ladite membrane rigide.

17. Capteur selon la revendication 16, caractérisé en ce qu'une électrode de référence (14) enterrée dans le substrat est prévue en regard de la membrane rigide.

18. Capteur selon la revendication 16, caractérisé en ce qu'il comporte au moins une première électrode (113) implantée dans le substrat (106) en regard d'une région (117) de déformation importante de la membrane (108) située à distance de la périphérie de la membrane et du plot isolant, et au moins une seconde électrode (111, 115) implantée dans le substrat en regard d'au moins une région de faible déformation de la membrane (108) située à proximité de la périphérie et/ou du plot isolant (124).

## Patentansprüche

1. Herstellungsverfahren eines integrierten Druckwandlers, der wenigstens eine verformbare, fest mit einem Substrat verbundene Membran und kapazitive Meßeinrichtungen der Verformungen dieser Membran umfaßt,
**dadurch gekennzeichnet,**
daß es die folgenden Schritte umfaßt:
a) - Implantieren von Sauerstoff-Ionen in ein Substrat (6) aus monokristallinem Silicium und Tempern des Substrats, um auf dem Substrat einen Film aus monokristallinem Silicium (44) zu bilden und von diesem letzteren wenigstens lokal durch eine Isolierschicht (42) zu trennen;
b) - Herstellen einer Öffnung (26) in diesem Siliciumfilm, bis zur Isolierschicht;
c) - partielles Eliminieren dieser Isolierschicht durch die genannte Öffnung, um die Siliciumfilm-Membran zu bilden;
d) - Verschließen der besagten Öffnung (26),
wobei das genannte Verfahren außerdem einen Herstellungsschritt von wenigstens einer in dem Siliciumsubstrat vergrabenen Elektrode (12, 111, 113, 115) umfaßt, der verformbaren Membran gegenüberstehend, und dieser Schritt nach dem Tempern des Substrats stattfindet.

2. Verfahren nach Anspruch 1, dadurch gekennzeichnet, daß der Schritt c) durch isotropen chemischen Angriff erfolgt.

3. Verfahren nach Anspruch 1 oder 2, dadurch gekennzeichnet, daß man vor dem Herstellen der Öffnung eine monokristalline Siliciumschicht (50) auf dem Siliciumfilm epitaktisch aufwachsen läßt.

4. Verfahren nach einem der Ansprüche 1 bis 3, dadurch gekennzeichnet, daß man die Meßeinrichtungen (8, 12) wenigstens teilweise in dem Siliciumfilm und/oder der epitaxierten Siliciumschicht ausbildet, die dann leitend sind, und dadurch, daß man für besagte Einrichtungen elektrische Kontakte (32, 34) auf dem leitenden Silicium herstellt.

5. Verfahren nach einem der vorangehenden Ansprüche, dadurch gekennzeichnet, daß das Substrat aus N-dotiertem monokristallinen Silicium ist.

6. Verfahren nach einem der vorangehenden Ansprüche, dadurch gekennzeichnet, daß der Schritt d) darin besteht, auf der Gesamtheit der Struktur wenigstens eine zusätzliche Schicht abzuscheiden und diese Schicht derart zu ätzen, daß nur am Ort der Öffnung Material stehenbleibt.

7. Verfahren nach Anspruch 6, dadurch gekennzeichnet, daß man einen Stapel aus zwei Isolierschichten aus Siliciumoxid und Siliciumnitrid verwendet, um die Öffnung wieder zu schließen.

8. Verfahren nach einem der vorangehenden Ansprüche, dadurch gekennzeichnet, daß die vergrabene Elektrode durch lokale Implantation von Ionen in das Substrat gebildet wird, deren Konduktivitätstyp zu dem des Substrats invers ist.

9. Verfahren nach einem der vorangehenden Ansprüche, dadurch gekennzeichnet, daß die Isolierschicht (42) auf der gesamten Oberfläche des Substrats ausgebildet wird.

10. Verfahren nach einem der vorangehenden Ansprüche zur Herstellung eines Wandlers mit kapazitiven Differentialmeßeinrichtungen, dadurch gekennzeichnet, daß es außerdem die simultane Herstellung einer Bezugsstruktur (4) mit einer steifen Membran (10) umfaßt, integriert auf dem genannten Substrat, die folgenden Schritte umfassend:
- Herstellen des leitenden Siliciumfilms, über seine gesamte Fläche vom Substrat getrennt;
- Herstellen mehrerer Öffnungen (26, 30) in dem Siliciumfilm, bis zur Isolierschicht;
- partielles Eliminieren der Isolierschicht durch wenigstens eine (26) der genannten Öffnungen;
- Verschließen der genannten Öffnungen durch Isolierstopfen (28);
- Herstellen von elektrischen Kontakten (34) auf dem leitenden Silicium.

11. Verfahren nach Anspruch 10, dadurch gekennzeichnet, daß man in dem Siliciumfilm eine erste Öffnung (26) bis zur Isolierschicht herstellt und die Isolierschicht durch diese erste Öffnung und zweite Öffnungen (30) in dem Siliciumfilm entfernt.

12. Verfahren nach Anspruch 10 oder 11, dadurch gekennzeichnet, daß man wenigstens eine in dem Siliciumsubstrat vergrabene Bezugselektrode (14) herstellt, der steifen Membran (10) gegenüberstehend.

13. Verfahren nach einem der Ansprüche 1 bis 14, dadurch gekennzeichnet, daß man außerdem eine periphere Ätzung des auf der Isolierschicht ausgebildeten Siliciums durchführt, um die Membran oder die Membrane (8, 10) zu isolieren.

14. Integrierter Druckwandler mit einer sensiblen Struktur (2), ein Siliciumsubstrat (6, 106), wenigstens eine Membran aus monokristallinem Silicium (8, 108), verformbar in einer zum Substrat senkrechten Richtung (Z), sowie Kondensator-Einrichtungen zum Messen der Membran-Verformungen umfassend, wobei besagte Membran mit ihren Rand über eine geätzten Isolierschicht (42, 42a) fest mit dem Substrat verbunden ist,
**dadurch gekennzeichnet,**
daß die Membran in ihrer Mitte einen isolierenden Stopfen (24, 124) umfaßt, wobei dieser Stopfen sich auf dem Substrat abstützt, um die Steifheit der Membran zu erhöhen, dadurch gekennzeichnet, daß wenigstens eine in dem Substrat vergrabene Elektrode (12) der verformbaren Elektrode gegenüber vorgesehen ist.

15. Wandler nach Anspruch 14, dadurch gekennzeichnet, daß die Membran kreisförmig ist.

16. Wandler nach Anspruch 14, dadurch gekennzeichnet, daß er eine Bezugsstruktur umfaßt, die wenigstens eine fest mit dem Substrat verbundene Membran (10) aus monokristallinem Silicium enthält, versteift durch mehrere über ihre gesamte Fläche verteilte Isolierstopfen (28), die sich auf dem Substrat abstützen, und elektrische Kontakte (34), ausgebildet auf der genannten steifen Membran.

17. Wandler nach Anspruch 16, dadurch gekennzeichnet, daß eine in dem Substrat vergrabene Bezugselektrode (14) der steifen Membran gegenüber vorgesehen ist.

18. Wandler nach Anspruch 16, dadurch gekennzeichnet, daß er wenigstens eine erste Elektrode (113) umfaßt, einem vom Rand der Membran und dem Isolierstopfen beabstandeten Bereich starker Verformung (117) der Membran (108) gegenüberstehend in das Substrat (106) implantiert, und wenigstens eine zweite Elektrode (111, 115), implantiert gegenüber wenigstens eines Bereichs schwacher Verformung der Membran (108), in der Nähe des Rands und/oder des Isolierstopfens (124).

## Claims

1. Process for the production of an integrated pressure transducer having at least one deformable diaphragm integral with a substrate and means for measuring the deformations of this diaphragm, characterized in that it comprises the following stages:
a) implantation of oxygen ions in a monocrystalline silicon substrate (6) and annealing the substrate in order to form a monocrystalline silicon film (44) on the substrate and separated from the latter, at least locally, by an insulating layer (42),
b) producing an opening (26) in the silicon film down to the insulating layer,
c) partial elimination of the insulating layer via the said opening in order to form the diaphragm in the silicon film,
d) resealing said opening (26),
said process also having a stage of producing at least one buried electrode (12, 111, 113, 115) in the silicon substrate facing the deformable diaphragm, said stage taking place following the annealing of the substrate.

2. Process according to claim 1, characterized in that the stage c) is performed by isotropic chemical etching.

3. Process according to claim 1 or 2, characterized in that a monocrystalline silicon layer (50) is epitaxied on the silicon film before making the opening.

4. Process according to any one of the claims 1 to 3, characterized in that the measuring means (8, 12) are at least partly formed in the silicon film and/or the epitaxied silicon layer, which are then conductive and in that electric contacts (32, 34) are produced on the conductive silicon for said means.

5. Process according to any one of the preceding claims, characterized in that the substrate is of N doped monocrystalline silicon.

6. Process according to any one of the preceding claims, characterized in that stage d) consists of depositing on the complete structure at least one additional layer and etching said layer so as to only retain material at the location of the opening.

7. Process according to claim 6, characterized in that use is made of a stack of two insulating layers respectively of silicon dioxide and silicon nitride for resealing the opening.

8. Process according to any one of the preceding claims, characterized in that the buried electrode is formed by the local implantation of ions in the substrate with a conductivity type opposite to that of the substrate.

9. Process according to any one of the preceding claims, characterized in that the insulating layer (42) is formed over the entire surface of the substrate.

10. Process according to any one of the preceding claims for the production of a transducer having differential capacitive measuring means, characterized in that it also comprises the simultaneous production of a reference structure (4) having a rigid diaphragm (10) integrated onto the said substrate and involving the following stages:
- producing a conductive silicon film separated from the substrate over its entire surface,
- producing several openings (26, 30) in the silicon film and extending down to the insulating layer,
- partial elimination of the insulating layer via at least one (26) of said openings,
- resealing said openings by means of the insulating studs (28),
- producing electric contacts (34) on the conductive silicon.

11. Process according to claim 10, characterized in that in the silicon film is produced a first opening (26) down to the insulating layer, an elimination of the insulating layer via said first opening and second openings (30) in the silicon film.

12. Process according to claim 10 or 11, characterized in that at least one buried reference electrode (14) is formed in the silicon substrate facing the rigid diaphragm (10).

13. Process according to any one of the claims 1 to 12, characterized in that there is also a peripheral etching of the silicon formed on the insulating layer in order to insulate the diaphragm or diaphragms (8, 10).

14. Integrated pressure transducer incorporating a sensitive structure (2) having a silicon substrate (6, 106), at least one deformable, monocrystalline silicon membrane (8, 108) in a direction (Z) perpendicular to the substrate and capacitor means for the measurement of the deformations of the membrane, said membrane being joined to the substrate by its periphery by means of an etched insulating layer (42, 42a), characterized in that the membrane is centrally provided with an insulating stud (24, 124), which bears on the substrate in order to increase the rigidity of the membrane and in that at least one electrode (12) buried in the substrate is provided facing the deformable membrane.

15. Transducer according to claim 14, characterized in that the diaphragm is circular.

16. Transducer according to claim 14, characterized in that it comprises a reference structure having at least one monocrystalline silicon diaphragm (10) joined to the substrate and made rigid by several insulating studs (28) distributed over its entire surface and bearing on the substrate, electric contacts (34) being formed on said rigid diaphragm.

17. Transducer according to claim 16, characterized in that there is a buried reference electrode (14) in the substrate facing the rigid diaphragm.

18. Transducer according to claim 16, characterized in that it has at least one first electrode (113) located in the substrate (106) facing a high deformation region (117) of the diaphragm (108) and remote from the periphery of the diaphragm and the insulating stud, and at least one second electrode (111, 115) facing at least one low deformation region of the diaphragm (108) and in the vicinity of the periphery and/or the insulating stud (124).
